Europäisches Patentamt

European Patent Office

Office européen des brevets

(19)

(11)  **EP 0 951 146 B1**

(12)  **EUROPEAN PATENT SPECIFICATION**

(45) Date of publication and mention
of the grant of the patent:
**28.05.2003   Bulletin 2003/22**

(51) Int Cl.[7]: **H03M 1/82**, H03K 9/08

(21) Application number: **99107006.1**

(22) Date of filing: **09.04.1999**

(54) **A digital-to-analog converter**

Digital-Analog-Wandler

Convertisseur numérique-analogique

(84) Designated Contracting States:
**DE ES FR GB SE**

(30) Priority: **14.04.1998  IT  TO980313**

(43) Date of publication of application:
**20.10.1999   Bulletin 1999/42**

(73) Proprietor: **IXFIN MAGNETI MARELLI SISTEMI
ELETTRONICI S.p.A.
20011 Corbetta (Milano) (IT)**

(72) Inventors:
  • **Diaco, Marco
    10060 Bricherasio (Torino) (IT)**

  • **Carbonaro, Piero
    10126 Torino (IT)**

(74) Representative: **Deambrogi, Edgardo et al
Jacobacci & Partners S.p.A.,
Corso Regio Parco, 27
10152 Torino (IT)**

(56) References cited:
  • **FIEGENBAUM W: "D-A-Umsetzer mit geringem
    Linearitätsfehler" RADIO FERNSEHEN
    ELEKTRONIK., vol. 31, no. 5, May 1982, pages
    294-298, XP002088143 BERLIN DD**
  • **PATENT ABSTRACTS OF JAPAN vol. 013, no.
    584 (E-866), 22 December 1989 -& JP 01 245622
    A (HORIBA LTD), 29 September 1989**

## Description

The present invention relates to a digital-to-analog converter circuit (D/A) according to the preamble to Claim 1 and, in particular, relates to a D/A converter for driving a two-quadrant current generator with a floating load.

It is known in the art for D/A converters for converting a numerical quantity processed by a microprocessor, to be implemented simply with the use of a digital-to-analog converter circuit of known type, for example, a potentiometric or weighted-currents converter circuit, which is connected to the microprocessor externally if no integrated internal D/A converter is available.

It is also known to produce D/A converters operating on the basis of a pulse-width-modulated signal (referred to below for simplicity by the usual name of PWM signal) which is supplied by a microprocessor and the duty cycle of which is proportional to the numerical quantity to be converted. These converters (commonly known as indirect converters) generally comprise a low-pass filter for extracting the mean value of the PWM signal and a circuit arranged for varying the amplitude of the signal thus obtained in a predefined manner in order to achieve the desired dynamic range at the output.

The solutions currently used require expensive and complex components.

To prevent these problems, the subject of the invention is a D/A converter the main characteristics of which are defined in the appended main claim.

Further characteristics and advantages of the invention will become clear from the following detailed description given purely by way of non-limiting example, with reference to the appended drawings, in which:

Figure 1 is a block diagram of the digital-to-analog converter circuit according to the invention,

Figure 2 is a circuit diagram of a portion of the converter circuit identified by the frame II in Figure 1, and

Figure 3 is a set of graphs showing the curves of the input and output signals of the circuit blocks illustrated in Figure 1 as functions of time t.

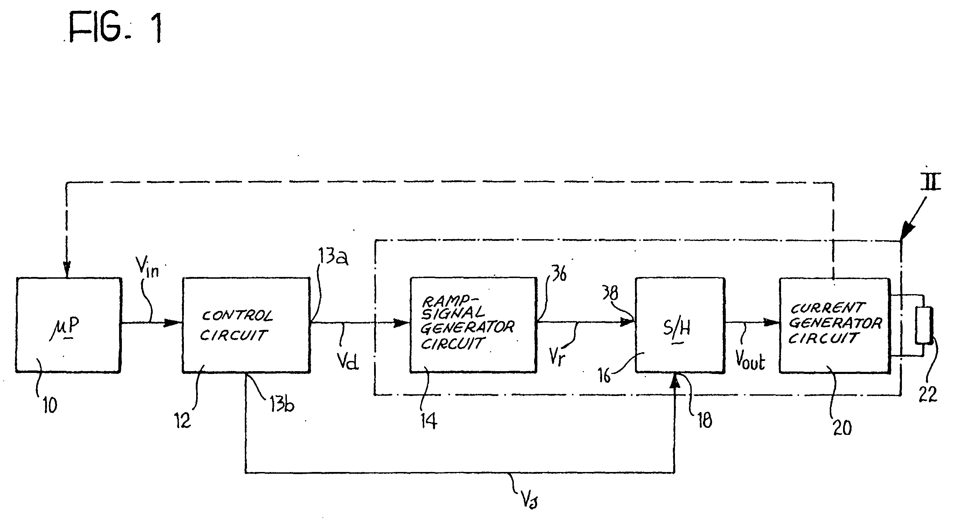

In Figure 1, a microprocessor, indicated 10, is arranged for processing a numerical variable and for generating a pulse-width-modulated (PWM) signal $V_{in}$ the duty-cycle of which is proportional to the value of the numerical variable.

The signal $V_{in}$ output by the microprocessor is supplied as an input to a D/A converter circuit comprising a control circuit 12 which generates an intermediate signal $V_d$, which is also a PWM signal, at a first output 13a, on the basis of the signal $V_{in}$, a circuit 14 for generating a ramp signal $V_r$, connected to the first output 13a of the control circuit 12, and a sample-and-hold (S/H) circuit 16 to the input of which the ramp signal $V_r$ is transferred.

The control circuit 12 also generates, at a second output 13b, a control signal $V_s$, sent to the control input 18 of the S/H circuit 16.

An analog signal $V_{out}$ corresponding to the input signal $V_{in}$ is output by the S/H circuit 16 at the output of the converter as a whole.

This analog signal $V_{out}$ can be used, for example, as described in the preferred embodiment, for driving a current-generator circuit 20 of known type, to which a floating load 22 is connected. There is provision for possible feedback control of the converter by the connection of the circuit 20 to an input of the microprocessor 10 so as to cancel out any errors which may arise and be amplified during the operation of the cascaded circuits 12, 14 and 16.

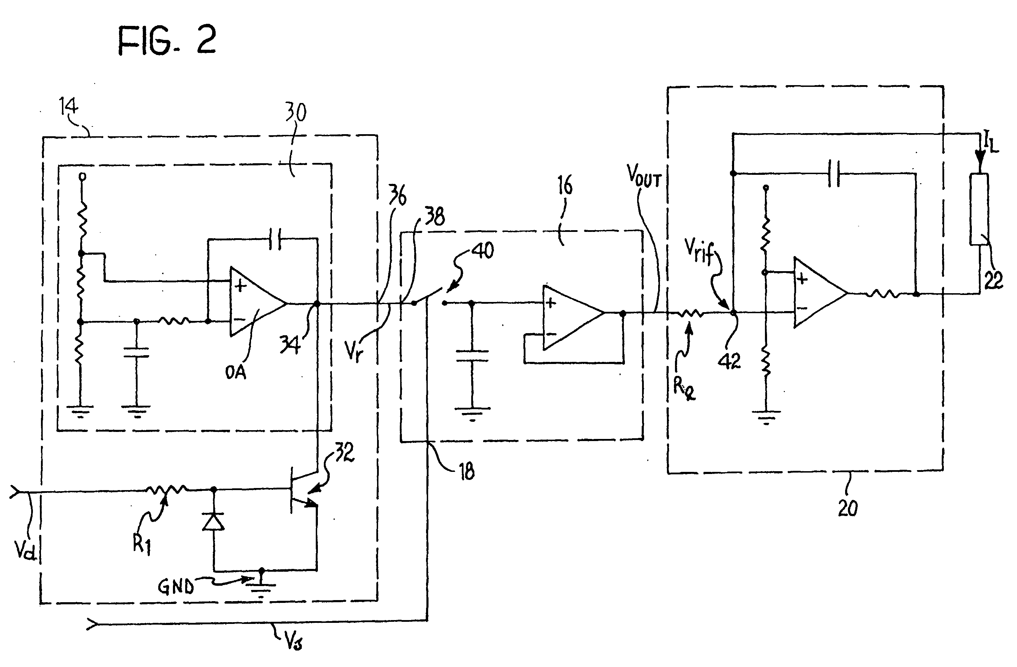

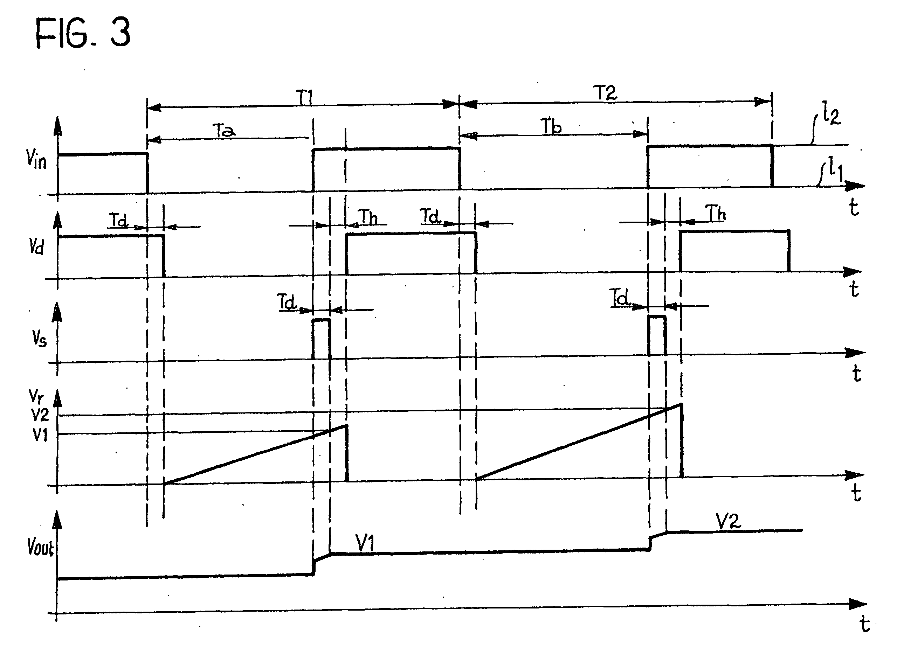

The operation of the circuit is now analyzed in detail below with reference to Figures 2 and 3.

The first graph of Figure 3 shows a time portion of the input signal $V_{in}$ comprising two complete periods of equal duration, indicated $T_1$ and $T_2$. The signal $V_{in}$ is a digital signal with two levels indicated as a first level $I_1$ and a second level $I_2$, respectively, corresponding, for example, to voltage values of 0 volts and 5 volts, respectively. The numerical data processed by the microprocessor 10 is now associated with the duty cycle of the signal $V_{in}$ and is represented by the time intervals $T_a$ and $T_b$ in which it is at the first level $I_1$, relative to the total duration of the periods $T_1$ and $T_2$.

The control circuit 12 receives the signal $V_{in}$ as an input and generates the corresponding intermediate signal $V_d$ at its first output 13a, as indicated in the second graph of Figure 3. The signal $V_d$ is obtained by delaying the moments at which the input signal $V_{in}$ switches, particularly by introducing a predetermined fixed delay $T_d$, and by delaying the switching of the signal from the first level $I_1$ to the second level $I_2$ by a further time interval, indicated $T_h$.

These measures are adopted in order to achieve correct sampling of the ramp signal $V_r$, as will be described further below.

The ramp-signal generator circuit 14 is illustrated in detail in Figure 2 and comprises an integrator circuit 30 of known type and an electronic switch 32 connected between the output 34 of the integrator and a ground terminal GND. In this embodiment, the switch 32 is formed, for example, by an npn-type bipolar transistor.

The control input of the switch 32 (the base of the transistor) receives the signal $V_d$ via a resistor $R_1$.

When the signal $V_d$ is at its first level $I_1$, the corresponding voltage value, for example 0 volts, is not sufficient to forward bias the base-emitter junction of the transistor 32 and this transistor operates in the cut-off condition, behaving substantially as an open switch and disconnecting the output 34 of the integrator from the ground terminal GND. The voltage signal $V_r$ provided by

the integrator and having a ramp-type variable amplitude (in particular, in the embodiment described, an increasing amplitude) therefore occurs at the output terminal 36 of the circuit 14.

When the input signal switches to its second level $I_2$, the corresponding voltage value, for example 5 volts, is sufficient to forward bias the base-emitter junction of the transistor 32 and this transistor operates in a saturation condition, behaving substantially as a closed switch and connecting the output 34 of the integrator to the ground terminal GND. The output terminal 36 of the circuit 14 is thus forced to the constant voltage of the ground terminal.

The time curve of the signal $V_r$ corresponding to the curves of the signals $V_{in}$ and $V_d$ is given in the fourth graph of Figure 3. The duty cycle of the signal $V_{in}$ regulates the maximum voltage reached by the ramp, which in any case cannot exceed the value of the saturation voltage of the operational amplifier OA of the integrator circuit 30.

The signal $V_r$ appears at the input 38 of the S/H circuit 16 and is acquired at predefined short time intervals by the closure of a switch 40. These intervals, hereinafter referred to as acquisition intervals of duration $T_d$, are determined by the signal $V_s$ (represented in the third graph of Figure 3) emitted by the control circuit 12 at the moments when the input signal $V_{in}$ switches from its first level $I_1$ to its second level $I_2$.

Since the signal $V_r$ is generated on the basis of the intermediate signal $V_d$, consecutive time intervals in which the signal $V_r$ has a ramp-type variable amplitude and in which, on the other hand, it is at the voltage of the ground terminal (GND) occur with a delay relative to the corresponding time intervals in which the signal $V_{in}$ input to the converter is at its first level $I_1$ and at its second level $I_2$, respectively. In the embodiment described, this delay is equal to the acquisition interval $T_d$ required by the sample-and-hold circuit 16.

During the acquisition interval, the signal $V_r$ thus still has a ramp-type variable amplitude and, in particular, a value close to the maximum value which can be reached and beyond which the voltage is brought to the value of the ground potential by the connection of the output 36 of the ramp generator circuit 14 to the ground terminal (GND).

The S/H circuit 16, which is implemented in accordance with known teachings, acquires the voltage reached by the signal $V_r$ and keeps this value at its output until the subsequent acquisition.

To permit correct acquisition, the signal $V_r$ must be kept relatively stable even for a short period after the theoretical acquisition interval. This is again provided for by the control circuit 12 by delaying the switching of the signal $V_d$ from the first level $I_1$ to the second level $I_2$ for a further holding time interval $T_h$ after the acquisition interval so as to delay the instantaneous forcing of the amplitude of the signal $V_r$ to the value of the ground potential, preventing problems and incorrect operation due to non-controllable opening times of the switch 40.

The voltage signal $V_{out}$ output by the S/H circuit constitutes the desired analog signal corresponding to the digital input signal $V_{in}$ and is represented in the last graph of Figure 3. This signal can be programmed by means of the numerical variable stored in the microprocessor 10.

A current signal can be generated on the basis of the analog voltage signal $V_{out}$ by means of the current generator circuit 20 which is also known from the literature.

The current $I_L$ supplied to the load 22 is given by the following equation:

$$I_L = \frac{V_{out} - V_{rif}}{R_2}$$

and is independent of the impedance of the load but depends solely upon the analog voltage signal corresponding to the digital input signal $V_{in}$ (and hence to the value of the numerical variable), and upon a predetermined reference voltage signal $V_{rif}$ present at the node 42 of the circuit 20. The current $I_L$ can be made to adopt both positive and negative values by suitable selection of the signal $V_{rif}$ at a voltage value between the maximum and minimum values which can be reached by the signal $V_{out}$ and by regulating the duty cycle of the signal $V_{in}$ (that is, by altering the numerical variable which controls it).

By feeding the signals $V_{out}$ and $V_{rif}$ back to an analog-to-digital converter circuit which is not shown because it is integrated in the microprocessor 10, it is also possible to calculate the value of the current $I_L$ numerically and to correct the duty cycle of the signal $V_{in}$ in order to modify it.

**Claims**

1.  A digital-to-analog converter circuit (D/A) for converting a pulse-width modulated (PWM), digital input signal ($V_{in}$) with two. stages or levels ($I_1$, $I_2$) into a corresponding analog output signal ($V_{out}$), **characterized in that** it comprises:

    a control circuit (12) having an input for receiving the digital input signal ($V_{in}$) and a first output (13a) by means of which the control circuit provides an intermediate signal ($V_d$) obtained by delaying the moments at which the input signal ($V_{in}$) switches,

    means (14) for generating a ramp signal ($V_r$), connected to the first output (13a) of the control circuit (12) and capable of being driven by the intermediate signal ($V_d$) in a manner such as to

generate a signal ($V_r$) having a ramp-type variable amplitude when the intermediate signal ($V_d$) is at a first level ($I_1$) and a substantially constant predetermined amplitude when the intermediate signal ($V_d$) is at a second level ($I_2$), and

a sample-and-hold (S/H) circuit (16) having an input (38) connected to the output (36) of the means (14) for generating the ramp signal ($V_r$) and a control input (18) connected to a second output (13b) of the control circuit (12), the sample-and-hold circuit (16) being driven by the control circuit (12) in a manner such as to acquire the amplitude reached by the signal ($V_r$) emitted by the generator means (14) each time the digital input signal ($V_{in}$) switches from the first level ($I_1$) to the second level ($I_2$), the signal at the output of the sample-and-hold circuit (16) constituting an analog signal ($V_{out}$) corresponding to the digital input signal ($V_{in}$).

2. A circuit according to Claim 1, **characterized in that** the intermediate signal ($V_d$) is obtained by delaying the moments at which the input signal ($V_{in}$) switches by a predetermined time at least equal to the acquisition time ($T_d$) required by the sample-and-hold circuit (16).

3. A circuit according to Claim 1 or Claim 2, **characterized in that** the means (14) for generating the ramp signal ($V_r$) comprise:

an integrator circuit (30) arranged for supplying an output voltage ($V_r$) with an amplitude variable in accordance with a linear ramp, and

an electronic switch (32) connected between the output (34) of the integrator circuit (30) and a conductor which is kept at a reference potential (GND), the intermediate digital signal ($V_d$) being applied to the control input of the electronic switch in operation.

4. A circuit according to Claim 3, **characterized in that** the electronic switch (32) is connected between the output (34) of the integrator circuit (30) and a ground conductor (GND).

5. A circuit according to any one of the preceding claims, **characterized in that** a current generator (20) with a floating load (22) is connected to the output of the sample-and-hold circuit (16).

**Patentansprüche**

1. Digital/Analog-Umsetzerstufe (D/A), um ein impulsbreitenmoduliertes (PWM), digitales Eingangssignal ($V_{in}$) mit zwei Stufen oder Pegeln ($I_1$, $I_2$) in ein entsprechendes analoges Ausgangssignal ($V_{out}$) umzusetzen, **dadurch gekennzeichnet, dass** die Umsetzerstufe enthält:

eine Steuerstufe (12) mit einem Eingang, um das digitale Eingangssignal ($V_{in}$) zu empfangen, und einem ersten Ausgang (13a), mit dem die Steuerstufe ein Zwischensignal ($V_d$) liefert, das man durch eine Verzögerung jener Zeitpunkte erhält, an denen das Eingangssignal ($V_{in}$) umschaltet,

eine Einrichtung (14), um ein Sägezahnsignal ($V_r$) zu erzeugen, wobei die Einrichtung mit dem ersten Ausgang (13a) der Steuerstufe (12) verbunden ist und mit dem Zwischensignal ($V_d$) so angesteuert werden kann, um ein Signal ($V_r$) zu erzeugen, das eine variable Sägezahnamplitude besitzt, wenn das Zwischensignal ($V_d$) auf einem ersten Pegel ($I_1$) liegt, und eine im Wesentlichen konstante, vorgegebene Amplitude besitzt, wenn das Zwischensignal ($V_d$) auf einem zweiten Pegel ($I_2$) liegt, und

eine Abtast/Halte (S/H) Stufe (16) mit einem Eingang (38) der mit dem Ausgang (36) der Einrichtung (14) verbunden ist, um das Sägezahnsignal ($V_r$) zu erzeugen, und mit einem Steuereingang (18), der mit einem zweiten Ausgang (13b) der Steuerstufe (12) verbunden ist, wobei die Abtast/Halte-Stufe (16) von der Steuerstufe (12) so angesteuert wird, um jene Amplitude zu erfassen, die das von der Generatorstufe (14) ausgesandte Signal ($V_r$) zu jedem Zeitpunkt erreicht, an dem das digitale Eingangssignal ($V_{in}$) vom ersten Pegel ($I_1$) auf den zweiten Pegel ($I_2$) umschaltet, wobei das Signal am Ausgang der Abtast/Halte-Stufe (16) ein analoges Signal ($V_{out}$) bildet, das dem digitalen Eingangssignal ($V_{in}$) entspricht.

2. Stufe gemäß Anspruch 1, **dadurch gekennzeichnet, dass** man das Zwischensignal ($V_d$) dadurch erhält, dass jene Zeitpunkte, an denen das Eingangssignal ($V_{in}$) umschaltet, um eine vorgegebene Zeitspanne verzögert werden, die zumindest gleich der Erfassungszeit ($T_d$) ist, die die Abtast/ Halte-Stufe (16) benötigt.

3. Stufe gemäß Anspruch 1 oder Anspruch 2, **dadurch gekennzeichnet, dass** die Einrichtung (14) zum Erzeugen des Sägezahnsignals ($V_r$) enthält:

eine Integratorstufe (30), die so aufgebaut ist, um eine Ausgangsspannung ($V_r$) zu liefern, die eine Amplitude besitzt, die in Übereinstimmung mit einem linearen Sägezahn variabel ist, und

einen elektronischen Umschalter (32), der zwischen dem Ausgang (34) der Integratorstufe (30) und einem Leiter liegt, der auf einem Bezugspotential (GND) gehalten wird, wobei das digitale Zwischensignal ($V_d$) im Betrieb an den Steuereingang des elektronischen Schalters gelegt wird.

**4.** Stufe gemäß Anspruch 3, **dadurch gekennzeichnet, dass** der elektronische Schalter (32) zwischen dem Ausgang (34) der Integratorstufe (30) und einem Masseleiter (GND) liegt.

**5.** Stufe gemäß irgendeinem der bisherigen Ansprüche, **dadurch gekennzeichnet, dass** ein Stromgenerator (20) mit einer sich dauernd ändernden Last (22) mit dem Ausgang der Abtast/Halte-Stufe (16) verbunden ist.

## Revendications

**1.** Circuit convertisseur numérique-analogique (N/A) destiné à convertir un signal d'entrée numérique ($V_{in}$) à largeur d'impulsions modulée (PWM) présentant deux paliers ou niveaux ($I_1$, $I_2$) en un signal de sortie analogique correspondant ($V_{out}$), **caractérisé en ce qu'**il comprend :

un circuit de commande (12) comportant une entrée pour recevoir le signal d'entrée numérique ($V_{in}$) et une première sortie (13a) au moyen de laquelle le circuit de commande délivre un signal intermédiaire ($V_d$) obtenu en retardant les instants auxquels le signal d'entrée ($V_{in}$) commute,
des moyens (14) destinés à générer un signal en dent de scie ($V_r$), connectés à la première sortie (13a) du circuit de commande (12) et aptes à étre attaqués par le signal intermédiaire ($V_d$) de manière à générer un signal ($V_r$) présentant une amplitude variable du type en dent de scie lorsque le signal intermédiaire ($V_d$) se trouve à un premier niveau ($I_1$) et une amplitude prédéterminée sensiblement constante lorsque le signal intermédiaire ($V_d$) se trouve à un second niveau ($I_2$), et
un circuit (16) d'échantillonnage et de blocage (S/H) comportant une entrée (38) connectée à la sortie (36) des moyens (14) destinés à générer le signal en dent de scie ($V_r$), et une entrée de commande (18) connectée à une seconde sortie (13b) du circuit de commande (12), le circuit d'échantillonnage et de blocage (16) étant attaqué par le circuit de commande (12) de manière à acquérir l'amplitude atteinte par le signal ($V_r$) émis par les moyens générateurs (14) chaque fois que le signal d'entrée numérique

($V_{in}$) commute du premier niveau ($I_1$) au second niveau ($I_2$), le signal, à la sortie du circuit d'échantillonnage et de blocage (16), constituant un signal analogique ($V_{out}$) correspondant au signal d'entrée numérique ($V_{in}$).

**2.** Circuit selon la revendication 1, **caractérisé en ce que** le signal intermédiaire ($V_d$) est obtenu en retardant les instants auxquels le signal d'entrée ($V_{in}$) commute, d'une durée prédéterminée au moins égale au temps d'acquisition ($T_d$) requis par le circuit d'échantillonnage et de blocage (16).

**3.** Circuit selon la revendication 1 ou 2, **caractérisé en ce que** les moyens (14) destinés à générer le signal en dent de scie ($V_r$) comprennent :

un circuit intégrateur (30) configuré pour délivrer une tension de sortie ($V_r$) présentant une amplitude variable conformément à une dent de scie linéaire, et
un commutateur électronique (32) connecté entre la sortie (34) du circuit intégrateur (30) et un conducteur qui est maintenu à un potentiel de référence (GND), le signal numérique intermédiaire ($V_d$) étant appliqué à l'entrée de commande du commutateur électronique en fonctionnement.

**4.** Circuit selon la revendication 3, **caractérisé en ce que** le commutateur électronique (32) est connecté entre la sortie (34) du circuit intégrateur (30) et un conducteur de masse (GND).

**5.** Circuit selon l'une quelconque des revendications précédentes, **caractérisé en ce qu'**un générateur de courant (20) comportant une charge flottante (22) est connecté à la sortie du circuit d'échantillonnage et de blocage (16).

# FIG. 1

EP 0 951 146 B1

FIG. 2

FIG. 3

EP 0 951 146 B1